# EUROPEAN PATENT APPLICATION

(11) **EP 4 614 809 A1**
(43) Date of publication of application: **10.09.2025**
(21) Application number: 24775242.1
(22) Date of filing: 25.03.2024
(51) Int. Cl.: H02S 50/00, G01R 21/133, H04B 17/309

(54) **INVERTER AND MAIN CONTROLLER OF PHOTOVOLTAIC POWER GENERATION SYSTEM, AND METHOD OF OPERATING PHOTOVOLTAIC SYSTEM**

(30) Priority: 23.03.2023 KR 20230038258
(71) Applicant: Hanwha Solutions Corporation, Jung-gu Seoul 04541 (KR)
(72) Inventor: PARK, Dong Il, Seoul 04541 (KR); NOH, Hong Il, Seoul 04541 (KR); YUN, Ju Hwan, Seoul 04541 (KR)
(74) Representative: Mooser, Sebastian Thomas
(86) International application number: PCT/KR2024/003710
(87) International publication number: WO 2024/196196

(57) **Abstract**

According to an embodiment of the present disclosure, there is provided an operation method of a photovoltaic power generation system for module-level power electronics (MLPE) firmware update, the method including obtaining firmware data, setting a version of the firmware data when the obtaining of the firmware data is completed, transmitting the firmware data, in which the version is set, to each of a plurality of MLPEs, receiving a reset readiness signal from each of the plurality of MLPEs after the transmitting of the firmware data is completed, and transmitting a firmware reset and update command to each of the plurality of MLPEs.

## Description

### Technical Field

The present disclosure relates to an inverter and a primary controller of a photovoltaic power generation system and an operation method of the photovoltaic power generation system, and more particularly, to an inverter and a primary controller of a photovoltaic power generation system and an operation method of the photovoltaic system ensure the stability and validity of module-level power electronics (MLPE) firmware updates.

### Background Art

In general, a photovoltaic power generation system is a system that converts solar energy into electrical energy using photovoltaic cells and transmits the electrical energy to a commercial power grid, and this process does not cause environmental pollution and enables the photovoltaic power generation system to be used semi-permanently.

Such a photovoltaic power generation system includes a plurality of photovoltaic panels, a plurality of module-level power electronics (MLPEs), a primary controller, and a server.

The plurality of photovoltaic panels may be connected in at least one of a series connection and a parallel connection, and each of the plurality of MLPEs is provided for each of the plurality of photovoltaic panels.

Each of the plurality of MLPEs includes an optimizer configured to optimize the power generation efficiency of the photovoltaic panel. Here, the optimizer optimizes the power efficiency of the photovoltaic panel and transmits power generation information including the power generation amount, temperature, and fault information of the photovoltaic panel to the primary controller.

The primary controller controls a plurality of optimizers, collects the power generation information received from each of the plurality of optimizers, and transmits the collected information to the server.

The server monitors the power generation status of the plurality of photovoltaic panels using the power generation information of each of the plurality of photovoltaic panels.

Meanwhile, the MLPE includes the optimizer and various other components implemented on a printed circuit board (PCB) and is provided in a molded state in a case of the MLPE. Accordingly, when modifications to the operation and control of the MLPE are required after the product has been finally shipped and installed on the photovoltaic panel, such modifications are made through a remote firmware update since the printed circuit board cannot be physically accessed for direct manipulation. Here, firmware refers to the software responsible for controlling and operating the MLPE.

However, when an error occurs during the remote firmware update process, the MLPE fails to reboot. In particular, when the firmware update is interrupted and subsequently resumed by continuously receiving firmware data, the validity of the data cannot be ensured when previously stored firmware data and the subsequently received firmware data have different versions.

### Disclosure

### Technical Problem

The present disclosure has been made in order to solve the above-described problems of the related art, and an object thereof is to ensure the validity of firmware data by maintaining the same version between previously stored firmware data and subsequently received firmware data when a firmware update is interrupted and subsequently resumed by continuously receiving firmware data.

The technical problems to be solved by the present disclosure are not limited to the problems mentioned above, and any other technical problems not mentioned herein will be clearly understood from the following description by those skilled in the art to which the present disclosure pertains.

### Technical Solution

According to an embodiment of the present disclosure, there is provided an operation method of a photovoltaic power generation system for module-level power electronics (MLPE) firmware update, the method including obtaining firmware data, setting a version of the firmware data when the obtaining of the firmware data is completed, transmitting the firmware data, in which the version is set, to each of a plurality of MLPEs, receiving a reset readiness signal from each of the plurality of MLPEs after the transmitting of the firmware data is completed, and transmitting a firmware reset and update command to each of the plurality of MLPEs.

In the present disclosure, the method may further include, after the setting of the version of the firmware data, transmitting an update command to each of the plurality of MLPEs, receiving an update readiness signal from each of the plurality of MLPEs, the update readiness signal including a memory space check result and version information of previously stored firmware data, and determining whether to transmit the firmware data based on the memory space check result and the version information of the previously stored firmware data.

In the present disclosure, in the determining of whether to transmit the firmware data, the set version of the obtained firmware data may be compared with a version of firmware data, which is previously stored in each of the plurality of MLPEs, and when the versions are the same or the version of the firmware data, which is previously stored, is higher, the firmware data may not be transmitted.

In the present disclosure, in the setting of the version of the firmware data, the version of the firmware data is set to increment each time obtaining entire data of the firmware data is completed.

In the present disclosure, in the transmitting of the firmware data, the firmware data may be divided into N unit data segments (where N is a natural number greater than or equal to 2), and the N unit data segments are sequentially transmitted to each of the plurality of MLPEs, an index may be set for each of the N unit data segments, wherein the index is incremented by 1 each time each of the plurality of MLPEs sequentially receives and stores the plurality of unit data segments, and a value of the index may range from 0 to (N-1).

In the present disclosure, each of the plurality of MLPEs may receive the firmware reset and update command, delete first firmware data that is previously stored, and receive and store second firmware data from the primary controller, and a version of the second firmware data may be different from a version of the first firmware data.

In the present disclosure, each of the plurality of MLPEs may receive third firmware data based on the interruption encountered while receiving the second firmware data, and receive the third firmware data as second-unit data segments.

In the present disclosure, each of the plurality of MLPEs may receive the second-unit data segments starting from an (i+1)-th second-unit data segment, based on an interruption after receiving an i-th first-unit data segment (where i is a natural number greater than or equal to 1 and less than N) among the first-unit data segments.

In the present disclosure, each of the plurality of MLPEs
may determine whether a version of the second-unit data segments is the same as a version of the first-unit data segments and receive the firmware data only when the version of the second-unit data segments is the same as the version of the first-unit data segments.

In the present disclosure, each of the plurality of MLPEs may transmit index information of the i-th first-unit data segment to the primary controller based on the version of the second-unit data segment being the same as the version of the first-unit data segment, and the primary controller may verify the index information of the i-th first-unit data segment and transmit the second-unit data segments to each of the plurality of MLPEs, starting from an (i+1)-th second-unit data segment.

In the present disclosure, each of the plurality of MLPEs may delete the second firmware data based on the version of the second-unit data segments being different from the version of the first-unit data segments, and the primary controller may transmit the second-unit data segments to each of the plurality of MLPEs, starting from a first second-unit data segment.

According to an embodiment of the present disclosure, there is provided an inverter of a photovoltaic power generation system, including a primary controller, for module-level power electronics (MLPE) firmware update, the inverter including a communication unit configured to obtain firmware data and transmit the received firmware data to each of a plurality of MLPEs; and a processor configured to set a version of the firmware data, determine whether to transmit the firmware data based on the version of the firmware data, and transmit a firmware reset and update command to each of the plurality of MLPEs in response to receiving a reset readiness signal from each of the plurality of MLPEs after the transmitting of the firmware data to each of the plurality of MLPEs is completed.

In the present disclosure, the processor may be further configured to, after the version of the firmware data is set, transmit an update command to each of the plurality of MLPEs, receive an update readiness signal from each of the plurality of MLPEs, and determine whether to transmit the firmware data based on a memory space check result and version information of previously stored firmware data, wherein the update readiness signal includes the memory space check result and the version information of the previously stored firmware data.

In the present disclosure, the processor may be further configured to compare the set version of the obtained firmware data with a version of the previously stored firmware data, and determine not to transmit the firmware data when the versions are the same or the version of the previously stored firmware data is higher.

In the present disclosure, the processor may be further configured to set such that the version of the firmware data is incremented each time obtaining entire data of the firmware data is completed, when the version of the firmware data is set.

In the present disclosure, the processor may be further configured to decide to sequentially transmit the firmware data, which includes version information and is divided into N unit data segments (where N is a natural number greater than or equal to 2), perform a firmware data update based on the version of the firmware data and an index of each of the N unit data segments, set the index for each of the N unit data segments, and increment the index by 1 each time the N unit data segments are sequentially received by each of the plurality of MLPEs.

In the present disclosure, the processor may be further configured to generate the firmware reset and update command, each of the plurality of MLPEs, upon receiving the firmware reset and update command, may be configured to delete first firmware data, which is previously stored, and receive and store second firmware data from the primary controller, and a version of the second firmware data may be different from a version of the first firmware data.

In the present disclosure, the processor may be further configured to transmit third firmware data based on the interruption encountered while receiving the second firmware data, and transmit the third firmware data as second-unit data segments.

In the present disclosure, the processor may be further configured to transmit the second-unit data segments starting from an (i+1)-th second-unit data segment, based on an interruption after receiving an i-th first-unit data segment (where i is a natural number greater than or equal to 1 and less than N) among the first-unit data segments.

According to an embodiment of the present disclosure, there is provided a primary controller of the photovoltaic power generation system configured to perform module-level power electronics (MLPE) firmware update, the primary controller including a communication unit configured to receive firmware data and transmit the received firmware data to each of a plurality of MLPEs; and a processor configured to transmit a firmware reset and update command to each of the plurality of MLPEs, in response to completion of firmware data transmission to each of the plurality of MLPEs and receiving a reset readiness signal from each of the plurality of MLPEs.

### Advantageous Effects

According to the present disclosure, when a firmware update is interrupted and subsequently resumed by continuously receiving firmware data, the validity of the data can be ensured by maintaining the same version between previously stored firmware data and the subsequently received firmware data.

Further, according to the present disclosure, when a firmware update is interrupted and subsequently received firmware data has a different version from previously stored firmware data, the validity of the data can be ensured by deleting the previously stored firmware data and updating the previously stored firmware data with new firmware data to maintain the same version.

The effects to be obtained from the present disclosure are not limited to those mentioned above, and any other effects not mentioned herein will be clearly understood from the following description by those skilled in the art to which the present disclosure pertains.

### Description of Drawings

FIGS. 1A and 1B are configuration diagrams illustrating examples of photovoltaic power generation systems according to an embodiment of the present disclosure.
FIG. 2 is a flowchart of an example of a photovoltaic power generation method according to an embodiment of the present disclosure.
FIG. 3 is an example of firmware data according to an embodiment of the present disclosure.
FIG. 4 is a diagram for describing a case in which an error occurs during firmware data transmission according to an embodiment of the present disclosure.
FIG. 5 is a block diagram of a module-level power electronics (MLPE) according to an embodiment of the present disclosure.
FIG. 6 is a diagram illustrating an MLPE firmware update sequence according to an embodiment of the present disclosure.
FIG. 7 is a flowchart of an MLPE firmware update method according to an embodiment of the present disclosure.

### Best Mode

The terms used in the embodiments have been selected from general terms that are currently widely used when possible but may vary according to an intention of those of ordinary skill in the art, precedents, or the emergence of new technologies. In addition, the applicant may arbitrarily select terms in a particular case, and in this case, the meaning of the terms will be described in detail in the corresponding part. Accordingly, the terms used herein should be defined on the basis of the meaning of the terms and the content throughout the specification, instead of the names of the terms.

Throughout the specification, when a part is referred to "include" a certain component, it means that it may further include other components rather than exclude other components, unless specifically indicates otherwise.

In addition, terms including ordinal numbers such as "first" or "second" used herein may be used to describe various components, but the components are not limited by the terms, and the terms are used only for the purpose of distinguishing one component from another. The terms may only be used to distinguish one component from another.

Hereinafter, embodiments will be described in detail with reference to the accompanying drawings. However, the embodiments may be implemented in several different forms and are not limited to embodiments that will be described below.

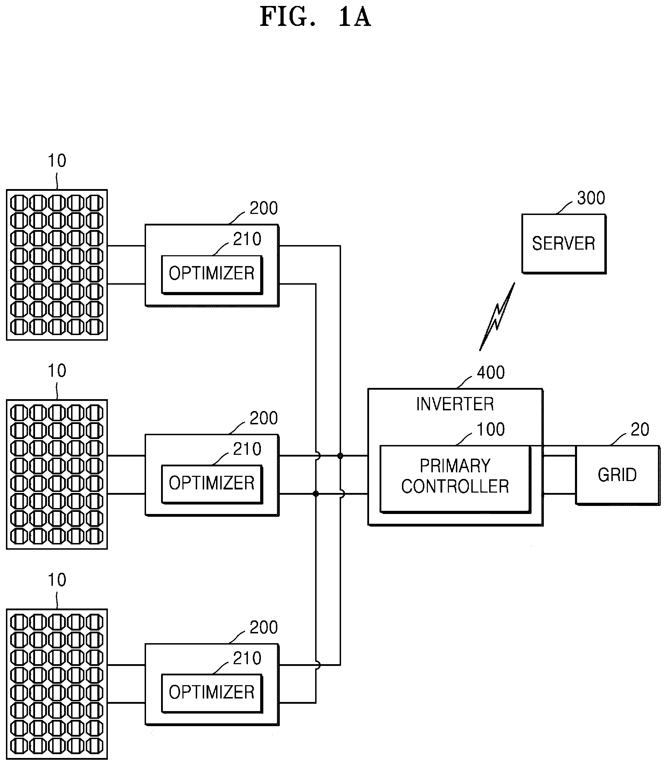

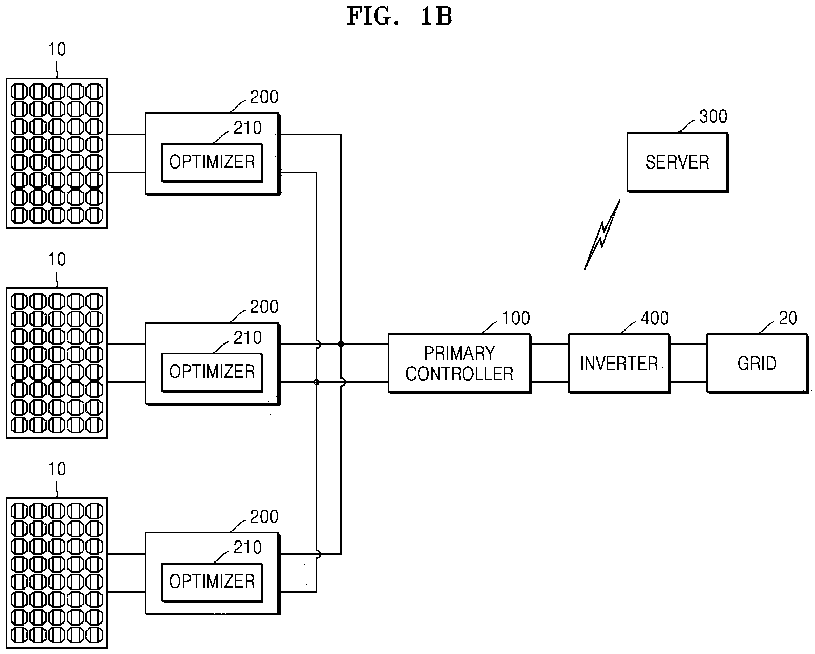

FIGS. 1A and 1B are configuration diagrams illustrating examples of photovoltaic power generation systems according to an embodiment of the present disclosure.

As illustrated in FIG. 1A, the photovoltaic power generation system according to an embodiment of the present disclosure may include a plurality of photovoltaic panels 10, an inverter 400 including a primary controller 100, a plurality of module-level power electronics (MLPEs) 200, and a server 300. Alternatively, as illustrated in FIG. 1B, a photovoltaic power generation system according to another embodiment of the present disclosure may include the plurality of photovoltaic panels 10, the primary controller 100, the plurality of MLPEs 200, the inverter 400, and the server 300.

That is, as shown in FIG. 1A, the photovoltaic power generation system according to an embodiment may be configured such that the inverter 400 includes the primary controller 100, and alternatively, according to another embodiment, as shown in FIG. 1B, the photovoltaic power generation system may be configured such that the inverter 400 is included between the primary controller 100 and a grid 20. Here, the inverter 400 may convert direct current (DC) power generated by the plurality of photovoltaic panels 10 into alternating current (AC) power and transmit the converted AC power to the grid 20.

Hereinafter, for convenience of description, an embodiment in which the primary controller 100 is included in the inverter 40, as shown in FIG. 1A, will be described as an example. Further, in the following description, the plurality of photovoltaic panels 10 and the plurality of MLPEs 200 will be collectively described, but, the photovoltaic panels 10 and the MLPEs 200 may be separate from each other and may be configured as different types or models.

According to an embodiment, each of the plurality of photovoltaic panels 10 may refer to a photovoltaic power generation panel in a module unit. Further, the plurality of photovoltaic panels 10 may be connected in at least one of a series connection and a parallel connection, and each of the plurality of MLPEs 200 may be provided for each of the plurality of photovoltaic panels 10. Further, one MLPE 200 may be connected to one photovoltaic panel 10, or one MLPE 200 may also be connected to the plurality of photovoltaic panels 10.

According to an embodiment, each of the plurality of MLPEs 200 includes a module-level inverter configured to convert the power generated by each of the photovoltaic panels 10 into AC power.

Further, according to an embodiment, each of the plurality of MLPEs 200 may include an optimizer 210 configured to optimize the power generation efficiency of the photovoltaic panel 10. Although referred to as the optimizer 210 in the present specification, the optimizer 210 does not denote a specific type of device but may be understood as a device that includes a power efficiency optimization function or a maximum power point tracking (MPPT) function. Here, the optimizer 210 operates in buck mode to lower an output voltage of the connected photovoltaic panel 10 when the output voltage is higher than the maximum power point and operates in boost mode to increase the output voltage when the output voltage is lower than the maximum power point, thereby optimizing power efficiency.

According to an embodiment, a plurality of optimizers 210 may perform a rapid shutdown to stop power generation of the photovoltaic panels 10 in an emergency situation. In addition, the plurality of optimizers 210 may transmit power generation information, including the power generation amount, temperature, and fault information of the photovoltaic panel 10, to the primary controller 100 and receive operation commands from the primary controller 100 to optimize power efficiency.

Here, information transmission and reception between the plurality of optimizers 210 and the primary controller 100 may be performed by a power line communication (PLC) method. When power line communication is used, separate communication cables or wireless communication technologies are not required for the information transmission and reception between the plurality of MLPEs 200 and the primary controller 100, thereby facilitating installation and maintenance of the photovoltaic power generation system. However, since power line communication utilizes power lines, communication may be more affected by line conditions or environmental factors compared to using communication cables.

According to an embodiment, the primary controller 100 may collect the power generation information received from the plurality of optimizers 210 and transmit the collected information to the server 300, and the server 300 may monitor the power generation status of the plurality of photovoltaic panels 10 using the power generation information of the plurality of photovoltaic panels 10.

Here, information transmission and reception between the primary controller 100 and the server 300 may be performed in a wired or wireless manner (e.g., serial communication).

The primary controller 100 may control the plurality of optimizers 210, i.e., the MLPEs 200, according to the power generation status of the photovoltaic panels 10. In addition, the primary controller 100 may receive firmware data from the server 300, transmit the firmware data to the MLPE after setting version information, and transmit a firmware update command to the MLPE, thereby performing a role in ensuring the stability and validity of the firmware update.

According to an embodiment of the present disclosure, in order to monitor the power generation status of the plurality of photovoltaic panels 10, the primary controller 100 transmits command data to the plurality of optimizers 210, and the plurality of optimizers 210 respond to the command data by transmitting response data, including the power generation information of the photovoltaic panels 10, to the primary controller 100. In addition, the primary controller 100 collects the power generation information of the plurality of photovoltaic panels 10 and transmits the collected information to the server.

Meanwhile, the MLPE 200 includes the optimizer 210 and various other components implemented on a printed circuit board (PCB) and is provided in a molded state within a case of the MLPE 200. Accordingly, when modifications to the operation and control of the MLPE 200 and the optimizer 210 are required after the product has been finally shipped and installed on the photovoltaic panel 10, such modifications are made through a remote firmware update since the printed circuit board cannot be physically accessed for direct manipulation. Here, firmware refers to the software responsible for controlling and operating the MLPE 200.

However, when an error occurs during the remote firmware update process, the MLPE 200 fails to reboot. In particular, when the firmware update is interrupted and subsequently resumed by continuously receiving firmware data, the validity of the data cannot be ensured when previously stored firmware data and the subsequently received firmware data have different versions.

Accordingly, the photovoltaic power generation system of the present disclosure proposes a technology that verifies a version of the firmware data and proceeds with the update when a firmware update is interrupted and subsequently resumed by continuously receiving firmware data.

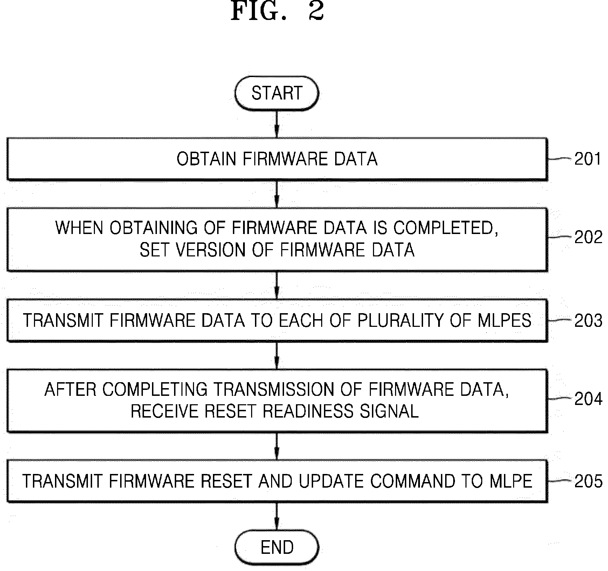

FIG. 2 is a flowchart of an example of a photovoltaic power generation method according to an embodiment of the present disclosure.

Referring to FIG. 2, first, the primary controller 100 receives firmware data from the server (201).

Next, when the reception of the firmware data is completed, the primary controller 100 sets a version for the firmware data (202).

Next, the primary controller 100 transmits the firmware data with the set version to each of the plurality of MLPEs (203).

Next, after the transmission of the firmware data is completed, the primary controller 100 receives an update readiness signal from the MLPE 200 and transmits a firmware update command to the MLPE 200 (204).

Next, a firmware update for the MLPE 200 is performed (205).

Hereinafter, specific operations of the photovoltaic power generation method for MLPE firmware updates will be described for each operation.

In detail, when a firmware update is required, the server 300 transmits firmware data to the primary controller 100, and the primary controller 100 receives the firmware update (201). Accordingly, the primary controller 100 receives the firmware data from the server 300, and when the reception of the firmware data is completed, sets a version for the firmware data.

Here, the primary controller 100 may increment the version of the firmware data each time the reception and storage of the firmware data are completed. At this time, the completion of the reception and storage of the firmware data means that all the data forming a complete piece of firmware software has been received and stored without any missing parts.

In more detail, as described above, the primary controller 100 may be present inside the inverter 400 or provided separately from the inverter 400 and may include a processor. According to an embodiment of the present disclosure, the primary controller 100 and the inverter 400 may be integrated and referred to as a control unit of the photovoltaic power generation system, and the control unit may further include an energy management system (EMS) board.

According to an embodiment of the present disclosure, within the control unit of the photovoltaic power generation system, the primary controller 100 may directly communicate with the MLPE via PLC communication, while the EMS board may communicate with the primary controller 100 via serial communication (Recommended Standard (RS)-485 in a more specific example). That is, in the photovoltaic power generation system, the primary controller 100 may communicate with other devices such as the inverter and the EMS board through serial communication such as RS-485.

Returning to operation 201 of FIG. 2, according to an embodiment of the present disclosure, obtaining the firmware update by the primary controller 100 may refer to transferring the firmware data provided by the server 300 from the EMS board to the primary controller 100 or transferring firmware data already stored in the EMS board to the primary controller 100.

Subsequently, when the reception of the firmware data is completed, the primary controller 100 may set a version of the firmware data (202). In more detail, according to an embodiment of the present disclosure, when the primary controller 100 receives the firmware data from the EMS board, the firmware data is stored in a flash memory of the primary controller 100 in binary form. In addition, when the entire firmware data is received, the version of the firmware data may be determined by reflecting the number of times the firmware data has been received. In more detail, the primary controller 100 may assign a serial number digit (SND) number for a single piece of firmware data.

Subsequently, according to an embodiment of the present disclosure, the primary controller 100 transmits the firmware update with the set version to each of the plurality of MLPEs 200 (203). In more detail, the primary controller 100 divides the firmware data into N unit data segments (where N is a natural number greater than or equal to 2) and sequentially transmits the N unit data segments to the MLPE 200. Here, the primary controller 100 may divide the firmware data, which has a size of several tens of kilobytes, into a plurality of units and transmit the plurality of units.

Alternatively, according to another embodiment of the present disclosure, the primary controller 100 may divide the firmware data into N unit data segments of a preset size and sequentially transmit the N unit data segments to the MLPE 200. That is, since a firmware capacity may vary depending on the version of the firmware data, instead of uniformly dividing the entire data into N segments, unit data may be generated with a preset size based on the communication environment.

Subsequently, according to an embodiment of the present disclosure, after the transmission of all divided unit data segments of the firmware data is completed, the primary controller 100 receives an update readiness signal from the MLPE 200 (204). Further, the primary controller 100, which has received the update readiness signal from the MLPE 200, transmits a firmware update command to the MLPE 200.

Meanwhile, according to an embodiment of the present disclosure, the primary controller 100 obtains a version of previously stored firmware data from the MLPE 200 and compares the version with a version of the newly transmitted firmware data. When the comparison result shows that the version of the previously stored firmware data is the same as or older than the version of the newly transmitted firmware data, the primary controller 100 does not transmit the update command to the MLPE 200.

The MLPE 200, which has received the firmware update command from the primary controller 100, verifies the version of the firmware data received from the primary controller 100 and performs a firmware data update. In more detail, the MLPE 200 compares the set version of the obtained firmware data with the version of the previously stored firmware data and does not perform the firmware update when the versions are the same or when the version of the previously stored firmware data is higher.

In detail, the MLPE 200, based on the need to update first firmware data that is previously stored, may delete the first firmware data and receive and store second firmware data with a different version from the first firmware data from the primary controller 100. That is, the MLPE 200 performs a reset and update of the firmware data. Here, the second firmware data may have a higher version than the first firmware data.

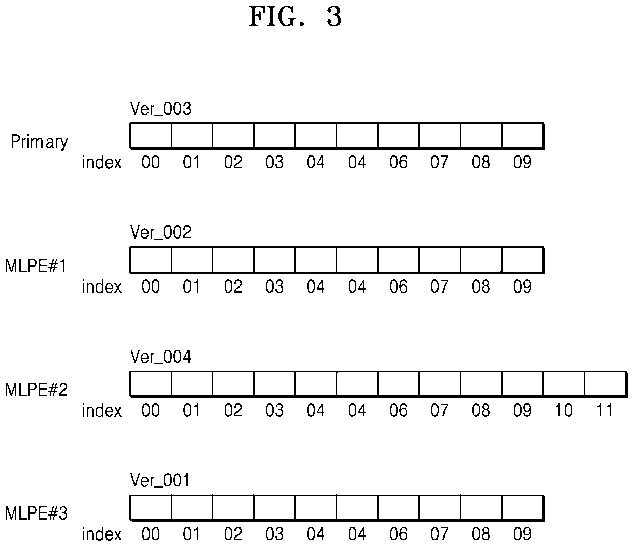

FIG. 3 is an example of firmware data according to an embodiment of the present disclosure.

Referring to FIG. 3, a version of firmware data obtained by the primary controller 100 (Primary) is Ver_003, and the firmware data is divided into ten unit data segments, each assigned an index ranging from 01 to 09.

Further, a version of firmware data previously stored in MLPE#1 is Ver_002, and the firmware data is divided into ten unit data segments, each assigned an index ranging from 01 to 09. That is, the firmware data previously stored in MLPE#1 may have been divided into ten segments and sequentially transmitted and installed.

Further, a version of firmware data previously stored in MLPE#2 is Ver_004, and the firmware data is divided into twelve unit data segments, each assigned an index ranging from 01 to 11. That is, the firmware data previously stored in MLPE#2 may have been divided into twelve segments and sequentially transmitted and installed, and may have a higher version and be larger in size than the data obtained by the primary controller 100.

Further, a version of firmware data previously stored in MLPE#3 is Ver_001, and the firmware data is divided into ten unit data segments, each assigned an index ranging from 01 to 19. That is, the firmware data previously stored in MLPE#3 may have been divided into ten segments and sequentially transmitted and installed, and may have a lower version and be smaller in size than the data obtained by the primary controller 100.

In the embodiment of FIG. 3, the primary controller 100 transmits an update command to each MLPE 200 based on the obtained firmware data and may receive version information of the previously stored firmware data from each MLPE 200. At this time, the primary controller 100 may not transmit firmware data when the versions are the same or when the version of the previously stored firmware data is higher. In more detail, the primary controller 100 may transmit the firmware data of Ver_003 to MLPE#1 and MLPE#3 but may not transmit the firmware data of Ver_003 to MLPE#2.

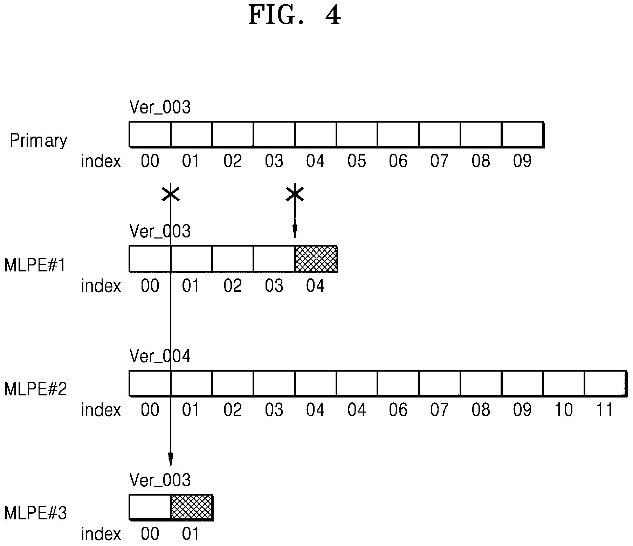

FIG. 4 is a diagram for describing a case in which an error occurs during firmware data transmission according to an embodiment of the present disclosure.

FIG. 4 continues the embodiment of FIG. 3 and provides an example in which the primary controller 100 divides the obtained firmware data of Ver_003 and sequentially transmits the firmware data of Ver_003 to MLPE#1 and MLPE#3.

As described above, the primary controller 100 divides second firmware data (obtained firmware data, which is the firmware data of Ver_003 in the embodiment of FIG. 4) into N first-unit data segments (N = 10 in the embodiment of FIG. 4) and may sequentially transmit the N first-unit data segments to MLPE#1 and MLPE#3. At this time, the primary controller 100 sets an index for each of the N first-unit data segments, and each time the MLPE 200 sequentially receives one of the N first-unit data segments of the second firmware data, the index may be incremented by 1. Here, a value of the index may range from 0 to (N-1). That is, an initial value of the index may be 0 and a last value of the index may be N-1.

For example, the primary controller 100 sets the index to 0 before a first first-unit data segment of the second firmware data is received, sets the index of a second first-unit data segment to 1 when it is confirmed that the MLPE 200 has received the first first-unit data segment, and sets the index to 2, when it is confirmed that the MLPE 200 has received the second first-unit data segment, thereby incrementing the index until the last unit data segment is received.

The N first-unit data segments may each include version information and index information. For example, the version information and index information may be included in a specific field of the packet of the first-unit data segment.

Meanwhile, while the primary controller 100 sequentially transmits the second firmware data, a transmission error may occur in the first-unit data segment corresponding to a fifth index (index = 04). In this case, MLPE#1 may receive third firmware data based on the interruption encountered while receiving the second firmware data. Here, the third firmware data may be received as second-unit data segments, and the second-unit data segments may each include version information and index information.

For example, the MLPE 200 may receive the second-unit data segments based on the interruption encountered while receiving the first-unit data segments up to an i-th first-unit data segment (where i is a natural number greater than or equal to 1 and less than N, and i = 5 in the embodiment of FIG. 4).

Here, the MLPE 200 may determine whether the version of the second-unit data segment is the same as the version of the previously stored first-unit data segment.

The MLPE 200 may transmit the index information of the i-th first-unit data segment to the primary controller 100 based on the version of the second-unit data segment being the same as the version of the first-unit data segment.

In addition, the primary controller 100 may verify the index information of the i-th first-unit data segment and transmit the second-unit data segments, starting from an (i+1)-th second-unit data segment to the MLPE 200.

In the embodiment of FIG. 4, both MLPE#1 and MLPE#3 have the same version of the second-unit data segment as the previously stored first-unit data segment. In this case, MLPE#1 transmits the index information of the i-th first-unit data segment (i = 4), which failed to be transmitted, to the primary controller 100, and MLPE#3 transmits the index information of the i-th first-unit data segment (i = 1), which failed to be transmitted, to the primary controller 100. Further, MLPE#1 and MLPE#3 resume receiving data from the primary controller 100, starting from fifth and second data segments, respectively.

Accordingly, when the firmware update is interrupted and subsequently resumed, the MLPE 200 can ensure data validity by maintaining the same version between the previously stored first-unit data segments and the subsequently received second-unit data segments while preserving continuity.

The MLPE 200 may delete the second firmware data based on the version of the second-unit data segment being different from the version of the first-unit data segment, and the primary controller 200 may transmit the second-unit data segments to the MLPE 200, starting from a first second-unit data segment. Here, the third firmware data may have a higher version than the second firmware data.

Accordingly, the MLPE 200 can ensure data validity by receiving and storing all of the plurality of unit data segments of the third firmware data from beginning to end instead of the second firmware data, thereby maintaining the same version and preserving continuity.

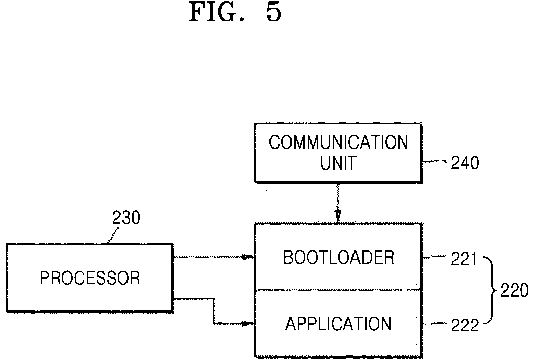

FIG. 5 is a block diagram of the MLPE according to an embodiment of the present disclosure.

Referring to FIG. 5, the MLPE according to an embodiment of the present disclosure may include a memory 220, a processor 230, and a communication unit 240. Meanwhile, these components may be integrated within the MLPE 200 as part of its own configuration.

The memory 220 may store firmware data and algorithms necessary for control operation of the MLPEs 200. Here, the memory 220 may be a flash memory (e.g., a read-only memory (ROM)) and may include an application 222 that operates based on the previously stored firmware data and a bootloader 221 that receives firmware data from the primary controller 100.

The communication unit 240 may sequentially receive firmware data, which has a set version and is divided into N unit data segments, from the primary controller 100. According to an embodiment of the present disclosure, the communication unit 240 of the MLPE 200 may transmit and receive data with the primary controller 100 through power line communication.

Further, the processor 230 may verify the index and the version of the firmware data and perform a firmware data update. In more detail, the processor 230 may check space in the memory 220 in response to a request from the primary controller 100, transmit an update readiness signal to the primary controller 100 upon confirming that the memory space is available, store the firmware data, which has been divided into N unit data segments and is received from the primary controller 100, in the memory, and perform a firmware reset and update based on a received reset and update signal.

Here, each of the N unit data segments has a set index, and the index may be incremented by 1 each time one of the N unit data segments is sequentially received and stored, where a value of the index may range from 0 to (N-1). In addition, the N unit data segments may each include version information and index information.

In detail, the processor 230, based on the need to update first firmware data that is previously stored in the memory 220, may delete the first firmware data and receive and store second firmware data with a different version from the first firmware data from the primary controller 100. Here, the second firmware data may be received as N first-unit data segments.

The processor 230 may receive third firmware data based on the interruption encountered while receiving the second firmware data. Here, the third firmware data may be received as second-unit data segments.

In detail, the processor 230 may receive the second-unit data segments based on the interruption encountered while receiving the first-unit data segments up to an i-th first-unit data segment (where i is a natural number greater than or equal to 1 and less than N, and i = 5).

Further, the processor 230 may determine whether a version of the second-unit data segment is the same as a version of the previously stored first-unit data segment.

The processor 230 may transmit index information of the i-th first-unit data segments to the primary controller 100 based on the version of the second-unit data segment being the same as the version of the first-unit data segment.

In addition, the primary controller 100 may verify the index information of the i-th first-unit data segment and transmit the second-unit data segments, starting from an (i+1)-th second-unit data segment to the MLPE 200.

Accordingly, in the firmware update device of the MLPE according to an embodiment of the present disclosure, when the reception of the first-unit data segments is interrupted during a second firmware update and the second-unit data segments are subsequently re-received, data validity can be ensured by maintaining the same version between the previously stored first-unit data segments and the subsequently re-received second-unit data segments while preserving continuity.

Conversely, when the version of the second-unit data segment is different from the version of the first-unit data segment, the processor 230 may delete the second firmware data, and the primary controller 200 may transmit the second-unit data segments to the MLPE 200 starting from a first second-unit data segment. Accordingly, in the firmware update device of the MLPE according to an embodiment of the present disclosure, data validity can be ensured by receiving and storing a plurality of unit data segments of the third firmware data from beginning to end instead of the second firmware data, thereby maintaining the same version and preserving continuity.

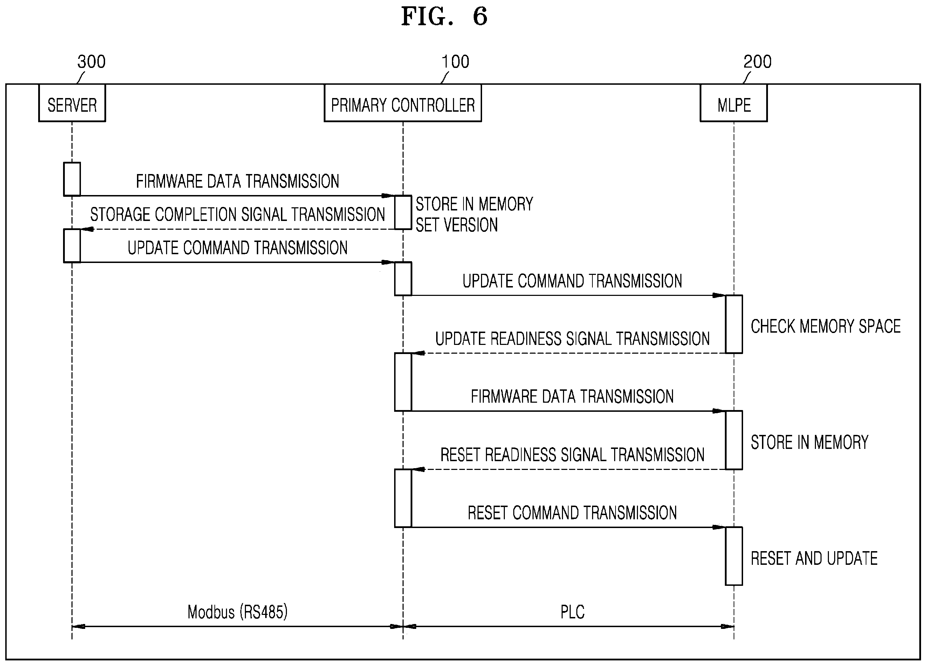

FIG. 6 is a diagram illustrating an MLPE firmware update sequence according to an embodiment of the present disclosure.

Referring to FIG. 6, the server 300 and the primary controller 100 may transmit and receive data and signals through serial communication (e.g., RS485), while the primary controller 100 and the MLPE 200 may transmit and receive data and signals through power line communication (PLC).

First, when the server 300 transmits firmware data to the primary controller 100, the primary controller 100 stores the firmware data in the memory (e.g., a flash memory (ROM)). At this time, the primary controller 100 sets a version for the firmware data when the reception and storage of the firmware data are completed.

Next, when the reception and storage of the firmware data in the memory are completed, the primary controller 100 transmits a storage completion signal to the server 300. Then, the server 300 transmits an update command to the primary controller 100. Here, the update command may include unique information of the MLPE 200 that requires a firmware data update.

Next, the primary controller 100 verifies the unique information of the MLPE 200 and transmits an update command to the MLPE 200 that requires a firmware data update. Then, the MLPE 200 checks space in the memory 220 and transmits an update readiness signal to the primary controller 100 when the memory 220 has sufficient space.

Next, the primary controller 100 transmits the firmware data with the set version to the MLPE 200. Then, MLPE 200 stores the firmware data with the set version.

Next, when previously stored firmware data needs to be updated, the MLPE 200 transmits a firmware data reset readiness signal to the primary controller 100. Then, the primary controller 100 transmits a reset and update command to the MLPE 200.

Next, the MLPE 200 deletes the previously stored firmware data according to the reset and update command, receives and stores new firmware data from the primary controller 100, and performs an update.

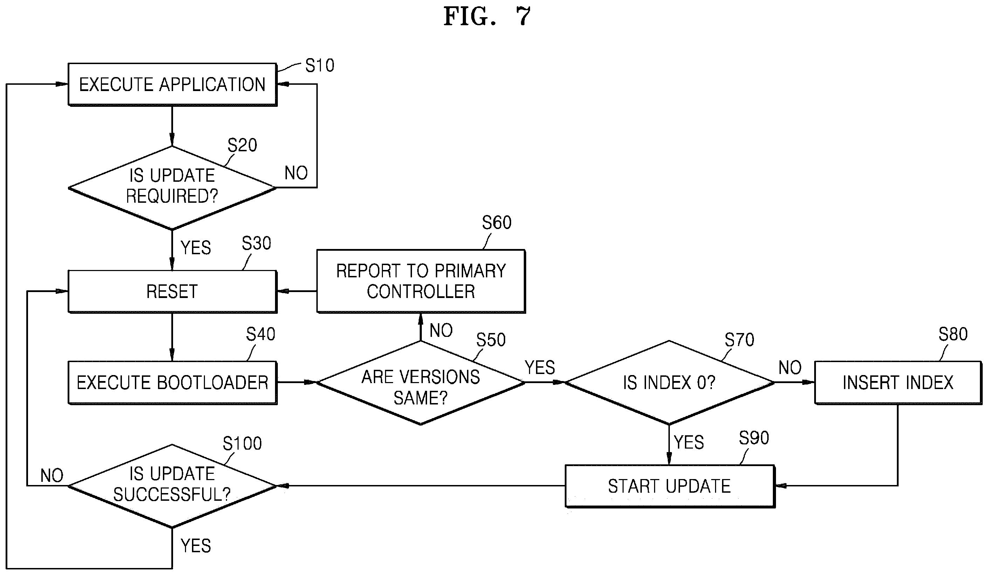

FIG. 7 is a flowchart of an MLPE firmware update method according to an embodiment of the present disclosure.

Referring to FIG. 7, in the MLPE firmware update method according to an embodiment of the present disclosure, first, the processor 230 executes the application 222, which operates based on the first firmware data previously stored in the memory 220, to control the MLPE 200 (S10).

Next, the processor 230 determines whether the first firmware data needs to be updated (S20).

Next, when the previously stored first firmware data needs to be updated, the processor 230 resets the application (S30) and executes the bootloader 221 (S40).

When the bootloader 221 is executed, second firmware data is divided into N first-unit data segments and sequentially received.

Here, each of the N first-unit data segments has an assigned index, and each time the MLPE 200 sequentially receives and stores one of the N first-unit data segments, the index is incremented by 1, where a value of the index may range from 0 to (N-1). In addition, the N first-unit data segments may each include version information and index information.

Conversely, when the first firmware data does not need to be updated, the processor 230 executes the application 222, which operates based on the first firmware data, to control the MLPE 200 (S10).

The processor 230 may receive third firmware data based on the interruption encountered while receiving the second firmware data. Here, the third firmware data may be received as second-unit data segments.

In detail, the processor 230 may receive the second-unit data segments based on the interruption encountered while receiving the first-unit data segments up to an i-th first-unit data segment (where i is a natural number greater than or equal to 1 and less than N, and i = 5).

Next, the processor 230 determines whether a version of the previously stored first-unit data segment is the same as a version of the second-unit data segment (S50).

Here, when the version of the second-unit data segment is different from the version of the first-unit data segment, the processor 230 reports this to the primary controller 100 (S60). In addition, the application 222 is reset (S30), and the bootloader 221 is executed (S40) to receive and store the third firmware data from the beginning, where the third firmware data has the same version as the second-unit data. At this time, the first-unit data segments of the previously stored second firmware data are deleted.

Next, the index information of the second-unit data segment is verified to determine whether an index value is 0 (S70). when the index value is 0, the third firmware data is received from the beginning, and the update is newly initiated (S90).

Next, it is determined whether the update is successful (S100), and when the update is successful, the application is executed (S10).

Accordingly, in the MLPE firmware update method according to an embodiment of the present disclosure, the N second-unit data segments of the third firmware data are received and stored from beginning to end instead of the second firmware data, thereby ensuring data validity by maintaining the same version for the N unit data segments and preserving continuity.

Alternatively, the processor 230 may transmit the index information of the i-th first-unit data segment to the primary controller 100 based on the version of the second-unit data segment being the same as the version of the first-unit data segment.

Next, the primary controller 100 verifies the index information of the i-th first-unit data segment and transmits the second-unit data segments to the MLPE 200, starting from an (i+1)-th second-unit data segment.

Next, the MLPE 200 resets the application 222 (S30), executes the bootloader 221 (S40), and the MLPE 200 receives the second-unit data segments, starting from the (i+1)-th second-unit data segment. At this time, since the (i+1)-th second-unit data segment has the same version as the first-unit data segment and its index value is not 0, the (i+1)-th second-unit data segment is inserted sequentially after the i-th first-unit data segment (S80), and the update begins (S90).

Accordingly, in the firmware update device of the MLPE according to an embodiment of the present disclosure, when the reception of the first-unit data segments is interrupted during a second firmware update and the second-unit data segments are subsequently re-received, data validity can be ensured by maintaining the same version between the previously stored first-unit data segments and the subsequently re-received second-unit data segments while preserving continuity.

Next, it is determined whether the update of the second firmware data is successful (S100). At this time, when the update is successful, the application 222 operating with the second firmware data is executed (S10), and when the update fails, the application 222 is reset, and the bootloader 221 is executed (S40).

Accordingly, in the MLPE firmware update method according to an embodiment of the present disclosure, when the second firmware update is interrupted and subsequently resumed, data validity can be ensured by maintaining the same version between the previously stored first-unit data segments and the subsequently received second-unit data segments while preserving continuity.

Meanwhile, the above-described method may be recorded as a program that may be executed on a computer, and may be implemented in a general-purpose digital computer operating the program using a computer-readable recording medium. In addition, the structure of the data used in the method described above may be recorded on a computer-readable recording medium through various means. Examples of the computer-readable recording medium include storage media such as magnetic storage media (e.g., ROM, floppy disks, hard disks, and the like), and optical read media (e.g., CD-ROMs, DVDs, and the like).

It will be understood by those skilled in the art to which the present embodiment pertains that the present disclosure may be implemented in modified forms without departing from the spirit and scope of the present disclosure. Therefore, the disclosed methods are should be considered in an illustrative aspect rather than a restrictive aspect. The scope of the present disclosure should be defined by the claims rather than the above-mentioned description, and equivalents to the claims should be interpreted to fall within the present disclosure.

### Explanation Of Reference Numerals Designating The Major Elements Of The Drawings

- 100:: primary controller
- 200:: MLPE
- 210:: optimizer
- 220:: memory
- 230:: processor
- 240:: communication unit
- 300:: server
- 400:: inverter

## Claims

1. An operation method of a photovoltaic power generation system for module-level power electronics (MLPE) firmware update, the method comprising:
obtaining firmware data;
setting a version of the firmware data when the obtaining of the firmware data is completed;
transmitting the firmware data, in which the version is set, to each of a plurality of MLPEs,
receiving a reset readiness signal from each of the plurality of MLPEs after the transmitting of the firmware data is completed; and
transmitting a firmware reset and update command to each of the plurality of MLPEs.

2. The operation method of claim 1, further comprising:
after the setting of the version of the firmware data,
transmitting an update command to each of the plurality of MLPEs;
receiving an update readiness signal from each of the plurality of MLPEs, the update readiness signal including a memory space check result and version information of previously stored firmware data; and
determining whether to transmit the firmware data based on the memory space check result and the version information of the previously stored firmware data.

3. The operation method of claim 1, wherein
in the determining of whether to transmit the firmware data,
the set version of the obtained firmware data is compared with a version of firmware data, which is previously stored in each of the plurality of MLPEs, and when the versions are the same or the version of the firmware data, which is previously stored, is higher, the firmware data is not transmitted.

4. The operation method of claim 1, wherein
in the setting of the version of the firmware data,
the version of the firmware data is set to increment each time obtaining entire data of the firmware data is completed.

5. The operation method of claim 1, wherein
in the transmitting of the firmware data,
the firmware data is divided into N unit data segments (where N is a natural number greater than or equal to 2), and the N unit data segments are sequentially transmitted to each of the plurality of MLPEs,
an index is set for each of the N unit data segments, wherein the index is incremented by 1 each time each of the plurality of MLPEs sequentially receives and stores the plurality of unit data segments, and a value of the index ranges from 0 to (N-1).

6. The operation method of claim 1, wherein
each of the plurality of MLPEs receives the firmware reset and update command, deletes first firmware data that is previously stored, and receives and stores second firmware data from the primary controller, and
a version of the second firmware data is different from a version of the first firmware data.

7. The operation method of claim 6, wherein each of the plurality of MLPEs receives third firmware data based on the interruption encountered while receiving the second firmware data, and receives the third firmware data as second-unit data segments.

8. The operation method of claim 7, wherein each of the plurality of MLPEs receives the second-unit data segments starting from an (i+1)-th second-unit data segment, based on an interruption after receiving an i-th first-unit data segment (where i is a natural number greater than or equal to 1 and less than N) among the first-unit data segments.

9. The photovoltaic power generation system of claim 7, wherein each of the plurality of MLPEs determines whether a version of the second-unit data segments is the same as a version of the first-unit data segments and receives the firmware data only when the version of the second-unit data segments is the same as the version of the first-unit data segments.

10. The photovoltaic power generation system of claim 7, wherein
each of the plurality of MLPEs transmits index information of the i-th first-unit data segment to the primary controller based on the version of the second-unit data segment being the same as the version of the first-unit data segment, and
the primary controller verifies the index information of the i-th first-unit data segment and transmits the second-unit data segments to each of the plurality of MLPEs, starting from an (i+1)-th second-unit data segment.

11. The operation method of claim 10,
each of the plurality of MLPEs deletes the second firmware data based on the version of the second-unit data segments being different from the version of the first-unit data segments, and
the primary controller transmits the second-unit data segments to each of the plurality of MLPEs, starting from a first second-unit data segment.

12. An inverter of a photovoltaic power generation system, including a primary controller, for module-level power electronics (MLPE) firmware update, the inverter comprising:
a communication unit configured to obtain firmware data and transmit the received firmware data to each of a plurality of MLPEs; and
a processor configured to set a version of the firmware data, determine whether to transmit the firmware data based on the version of the firmware data, and transmit a firmware reset and update command to each of the plurality of MLPEs in response to receiving a reset readiness signal from each of the plurality of MLPEs after the transmitting of the firmware data to each of the plurality of MLPEs is completed.

13. The inverter of claim 12, wherein the processor is further configured to, after the version of the firmware data is set, transmit an update command to each of the plurality of MLPEs, receive an update readiness signal from each of the plurality of MLPEs, and determine whether to transmit the firmware data based on a memory space check result and version information of previously stored firmware data, wherein the update readiness signal includes the memory space check result and the version information of the previously stored firmware data.

14. The inverter of claim 12, wherein the processor is further configured to compare the set version of the obtained firmware data with a version of the previously stored firmware data, and determine not to transmit the firmware data when the versions are the same or the version of the previously stored firmware data is higher.

15. The inverter of claim 12, wherein the processor is further configured to set such that the version of the firmware data is incremented each time obtaining entire data of the firmware data is completed, when the version of the firmware data is set.

16. The inverter of claim 12, wherein the processor is further configured to decide to sequentially transmit the firmware data, which includes version information and is divided into N unit data segments (where N is a natural number greater than or equal to 2), perform a firmware data update based on the version of the firmware data and an index of each of the N unit data segments, set the index for each of the N unit data segments, and increment the index by 1 each time the N unit data segments are sequentially received by each of the plurality of MLPEs.

17. The inverter of claim 12, wherein
the processor is further configured to generate the firmware reset and update command,
each of the plurality of MLPEs, upon receiving the firmware reset and update command, is configured to delete first firmware data, which is previously stored, and receive and store second firmware data from the primary controller, and
a version of the second firmware data is different from a version of the first firmware data.

18. The inverter of claim 17, wherein the processor is further configured to transmit third firmware data based on the interruption encountered while receiving the second firmware data, and transmit the third firmware data as second-unit data segments.

19. The operation method of claim 18, wherein the processor is further configured to transmit the second-unit data segments starting from an (i+1)-th second-unit data segment, based on an interruption after receiving an i-th first-unit data segment (where i is a natural number greater than or equal to 1 and less than N) among the first-unit data segments.

20. A primary controller of the photovoltaic power generation system configured to perform module-level power electronics (MLPE) firmware update, the primary controller comprising:
a communication unit configured to receive firmware data from a server and transmit the received firmware data to each of a plurality of MLPEs; and
a processor configured to transmit a firmware reset and update command to each of the plurality of MLPEs, in response to completion of firmware data transmission to each of the plurality of MLPEs and receiving a reset readiness signal from each of the plurality of MLPEs.
